# EUROPEAN PATENT APPLICATION

(11) **EP 3 447 809 A1**
(43) Date of publication of application: **27.02.2019**
(21) Application number: 18199572.1
(22) Date of filing: 13.07.2012
(51) Int. Cl.: H01L 33/38, H01L 33/40

(54) **SEMICONDUCTOR LIGHT EMITTING DEVICE**

(30) Priority: 12.12.2011 JP 2011271399
(62) Divisional of application: 12176369.2
(71) Applicant: ALPAD Corporation, Tokyo 100-6208 (JP)
(72) Inventor: Kojima, Akihiro, Tokyo (JP); Furuyama, Hideto, Tokyo (JP); Shimada, Miyoko, Tokyo (JP); Akimoto, Yosuke, Tokyo (JP)
(74) Representative: Hoffmann Eitle

(57) **Abstract**

A semiconductor light emitting device includes a semiconductor layer including a light emitting layer, a p-side electrode provided on a second surface of the semiconductor layer, and an n-side electrode provided on the semiconductor layer to be separated from the p-side electrode. The p-side electrode includes a plurality of contact metal selectively provided on the semiconductor layer in contact with the second surface, a transparent film provided on the semiconductor layer in contact with the second surface between the plurality of contact metal, and a reflective metal provided on the contact metal and on the transparent film in contact with the contact metal, the reflective metal including silver. A surface area of a surface of the reflective metal on the light emitting layer side is greater than the sum total of a surface area of the plurality of contact metal contacting the semiconductor layer.

## Description

### FIELD

Embodiments described herein relate generally to a semiconductor light emitting device.

### BACKGROUND

Although a nitride semiconductor light emitting device having a structure in which the p-side electrode includes a reflecting electrode of silver (Ag) and the like is known, silver does not have excellent contact resistance with nitride semiconductors.

### BRIEF DESCRIPTION OF THE DRAWINGS

FIG. 1 is a schematic cross-sectional view of a semiconductor light emitting device of a first embodiment;
FIG. 2A to FIG. 4D are schematic cross-sectional views illustrating a method for manufacturing the semiconductor light emitting device of the first embodiment;
FIGS. 5A to 5E are schematic plan views of the light emitting region of the second surface of the semiconductor layer where the p-side electrode is formed;
FIG. 6 is a schematic cross-sectional view of a semiconductor light emitting device of a second embodiment;
FIG. 7A to FIG. 9D are schematic cross-sectional views illustrating a method for manufacturing the semiconductor light emitting device of the second embodiment;
FIGS. 10A to 10F are schematic plan views of the light emitting region of the second surface of the semiconductor layer where the p-side electrode is formed;
FIG. 11 is a schematic cross-sectional view of a semiconductor light emitting device of a third embodiment;
FIG. 12 is a schematic cross-sectional view of a semiconductor light emitting device of a fourth embodiment;
FIG. 13A is a schematic cross-sectional view of a semiconductor light emitting device of a fifth embodiment; and
FIG. 13B is a schematic plan view illustrating an example of a planar pattern of an n-side electrode of the semiconductor light emitting device shown in FIG. 13A.

### DETAILED DESCRIPTION

In general, according to one embodiment, a semiconductor light emitting device includes a semiconductor layer including a light emitting layer, a p-side electrode provided on a second surface of the semiconductor layer, and an n-side electrode provided on the semiconductor layer to be separated from the p-side electrode. The p-side electrode includes a plurality of contact metal selectively provided on the semiconductor layer in contact with the second surface, a transparent film provided on the semiconductor layer in contact with the second surface between the plurality of contact metal, and a reflective metal provided on the contact metal and on the transparent film in contact with the contact metal, the reflective metal including silver. A surface area of a surface of the reflective metal on the light emitting layer side is greater than the sum total of a surface area of the plurality of contact metal contacting the semiconductor layer.

Embodiments will now be described with reference to the drawings. Components common to the embodiments and the drawings are marked with like reference numerals.

### First embodiment

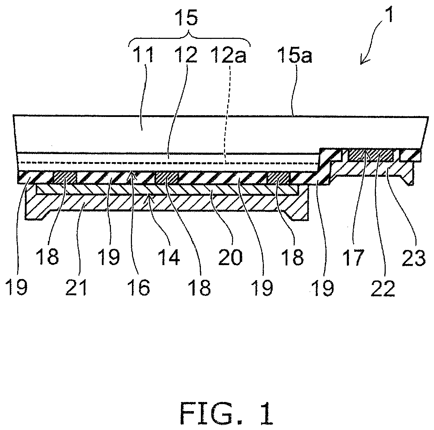

FIG. 1 is a schematic cross-sectional view of a semiconductor light emitting device 1 of a first embodiment.

The semiconductor light emitting device 1 includes a semiconductor layer 15; and light is emitted to the outside mainly from a first surface 15a of the semiconductor layer 15. A p-side electrode 14 and an n-side electrode 22 are provided on the second surface of the semiconductor layer 15 on the side opposite to the first surface 15a.

The semiconductor layer 15 includes a first semiconductor layer 11 and a second semiconductor layer 12. The first semiconductor layer 11 and the second semiconductor layer 12 are made of, for example, a material including gallium nitride. The first semiconductor layer 11 includes an n-type layer and the like that functions as a lateral-direction path of current. The second semiconductor layer 12 includes a p-type layer and a light emitting layer (an active layer) 12a.

The second surface of the semiconductor layer 15 is patterned into an uneven configuration; and a portion of the light emitting layer 12a is removed. Accordingly, the second surface of the semiconductor layer 15 has a light emitting region 16 opposing the light emitting layer 12a and a non-light emitting region 17 that does not oppose the light emitting layer 12a.

The p-side electrode 14 is provided in the light emitting region 16 of the second surface; and the n-side electrode 22 is provided in the non-light emitting region 17 of the second surface. The surface area of the light emitting region 16 of the second surface is greater than the surface area of the non-light emitting region 17. The surface area on the semiconductor layer 15 side (the light emitting layer 12a side) of the reflective metal 20 of the p-side electrode 14 that is described below is greater than the surface area of the n-side electrode 22 contacting the first semiconductor layer 11.

The p-side electrode 14 includes a plurality of contact metal 18, a silicon oxide film 19 as a transparent film that is transmissive with respect to the light emitted by the light emitting layer 12a, and the reflective metal 20 that is reflective with respect to the light emitted by the light emitting layer 12a.

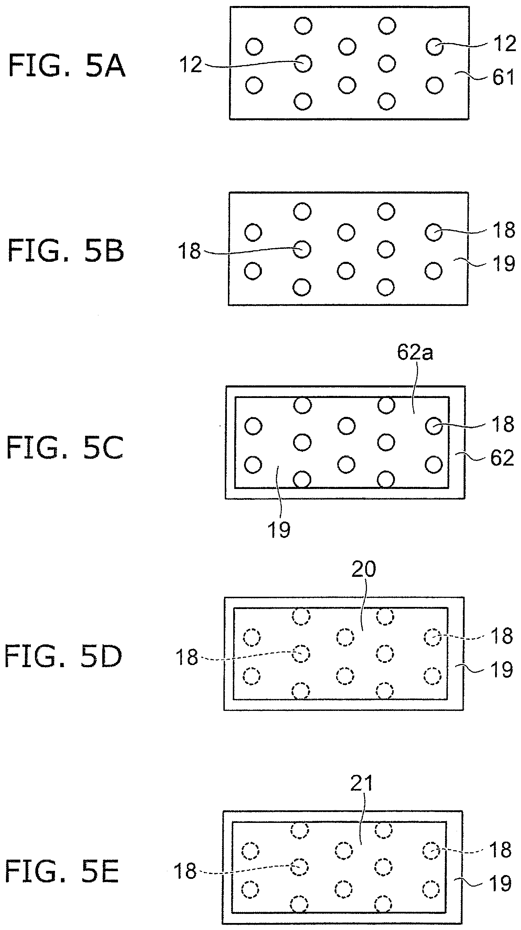

The plurality of contact metal 18 is selectively provided on the second semiconductor layer 12 in contact with the second surface of the semiconductor layer 15. As illustrated in FIG. 5B, the plurality of contact metal 18 has, for example, an island-like layout on the second surface. The planar configuration of the contact metal 18 is not limited to being circular and may be quadrilateral. Alternatively, the plurality of contact metal 18 may be formed in a lattice configuration or a line configuration.

The contact metal 18 has an ohmic contact with the second surface of the semiconductor layer 15. The contact metal 18 includes, for example, at least one selected from nickel (Ni), gold (Au), and rhodium (Rh) that is capable of forming an alloy with the gallium (Ga) included in the semiconductor layer 15.

The silicon oxide film 19 having a transmittance with respect to the light emitted by the light emitting layer 12a that is higher than that of the contact metal 18 is provided between the plurality of contact metal 18. The silicon oxide film 19 is provided on the second semiconductor layer 12 in contact with the second surface to fill between the plurality of contact metal 18.

The sum total of the surface area of the plurality of contact metal 18 contacting the second semiconductor layer 12 is less than the surface area of the light emitting region 16 of the second surface. The surface area of the silicon oxide film 19 on the light emitting region 16 is greater than the sum total of the surface area of the plurality of contact metal 18 when viewed in plan in FIG. 5B. More specifically, the surface area of the silicon oxide film 19 contacting the second semiconductor layer 12 is greater than the sum total of the surface area of the plurality of contact metal 18 contacting the second semiconductor layer 12; and the surface area of the silicon oxide film 19 contacting the reflective metal 20 is greater than the sum total of the surface area of the plurality of contact metal 18 contacting the reflective metal 20.

The silicon oxide film 19 covers a stepped portion between the light emitting region 16 and the non-light emitting region 17. The silicon oxide film 19 of the stepped portion insulates the p-side electrode 14 from the n-side electrode 22 and insulates the p-side pad metal 21 which is described below from the n-side pad metal 23 which is described below.

The reflective metal 20 is provided on the silicon oxide film 19 and the plurality of contact metal 18. As illustrated in FIG. 5D, the reflective metal 20 spreads over substantially the entire light emitting region 16 of the second surface. The reflective metal 20 contacts the plurality of contact metal 18 and is electrically connected to the plurality of contact metal 18.

The surface area of the surface of the reflective metal 20 on the semiconductor layer 15 side (the light emitting layer 12a side) is greater than the sum total of the surface area of the plurality of contact metal 18 contacting the second semiconductor layer 12. The surface area of the surface of the reflective metal 20 on the semiconductor layer 15 side (the light emitting layer 12a side) is greater than the sum total of the surface area of the plurality of contact metal 18 contacting the reflective metal 20. The surface area of the surface of the reflective metal 20 on the semiconductor layer 15 side (the light emitting layer 12a side) is greater than the surface area of a region linking the outermost circumference of the contact metal 18 when viewed in plan in FIG. 5D.

The film thickness of the contact metal 18 between the reflective metal 20 and the semiconductor layer 15 is substantially the same as the film thickness of the silicon oxide film 19 between the reflective metal 20 and the semiconductor layer 15; and the reflective metal 20 is provided on substantially a flat surface.

The reflectance of the reflective metal 20 with respect to the light emitted by the light emitting layer 12a is higher than that of the contact metal 18; and the reflective metal 20 includes silver (Ag) as the main component. A silver film may be used as the reflective metal 20; and a silver alloy film may be used as the reflective metal 20. Stated conversely, the contact metal 18 includes a metal material having a reflectance with respect to the light emitted by the light emitting layer 12a that is lower than that of the reflective metal 20; and as described above, the contact metal 18 includes, for example, at least one selected from nickel (Ni), gold (Au), and rhodium (Rh).

However, the contact resistance between the contact metal 18 and the semiconductor layer 15 is lower than the contact resistance in the case where the reflective metal 20 contacts the semiconductor layer 15. In other words, the Schottky barrier height between the contact metal 18 and the semiconductor (the nitride semiconductor) of the portion of the semiconductor layer 15 contacting the contact metal 18 is less than the Schottky barrier height between the nitride semiconductor and the reflective metal 20. Accordingly, when a positive potential is applied to the p-side electrode 14, more current flows from the metal into the semiconductor in the structure in which the contact metal 18 contacts the semiconductor layer 15 than in a structure in which the reflective metal 20 contacts the semiconductor layer 15.

The reflective metal 20 which includes silver functions as a reflective film such that the light travelling toward the side opposite to the first surface 15a which is the main extraction surface of the light to the outside is reflected by the reflective metal 20 toward the first surface 15a side.

The reflectance of silver is high for wavelengths in the visible region and is 98% with respect to light of 600 nm or more, 98% with respect to light near 500 to 600 nm, and 97% with respect to light near 450 to 500 nm.

However, ohmic contact is not easily provided between silver and GaN. Therefore, according to the embodiment, the contact metal 18 contacts the semiconductor layer 15 without the reflective metal 20 contacting the semiconductor layer 15. In other words, in the p-side electrode 14, the contact metal 18 provides the electrical conduction to the semiconductor layer 15.

The reflective metal 20 is provided to spread over substantially the entire light emitting region 16 of the second surface; and the sum total of the surface area of the plurality of contact metal 18 that contacts the semiconductor layer 15 and has a reflectance lower than that of the reflective metal 20 is less than the surface area of the surface of the reflective metal 20 on the semiconductor layer 15 side.

Accordingly, according to the embodiment, both high light reflectivity and low contact resistance of the p-side electrode 14 of the semiconductor light emitting device 1 can be realized.

At the portion between the second surface of the semiconductor layer 15 and the reflective metal 20 where the contact metal 18 is not provided, the silicon oxide film 19 is provided as a transparent film having a higher transmittance than that of the contact metal 18 with respect to the light emitted by the light emitting layer 12a. The surface area of the surface of the silicon oxide film 19 on the semiconductor layer 15 side is greater than the sum total of the surface area of the plurality of contact metal 18 contacting the semiconductor layer 15; and the surface area of the surface of the silicon oxide film 19 on the reflective metal 20 side is greater than the sum total of the surface area of the plurality of contact metal 18 contacting the reflective metal 20. Accordingly, a large reflective surface can be ensured for the surface of the reflective metal 20 on the semiconductor layer 15 side (the light emitting layer 12a side).

The p-side pad metal 21 is provided on the reflective metal 20. The p-side pad metal 21 also covers the end portion (the side surface) of the reflective metal 20. The p-side pad metal 21 is thicker than the reflective metal 20.

The p-side pad metal 21 includes, for example, a titanium (Ti) film, a platinum (Pt) film, and a gold (Au) film stacked in order from the reflective metal 20 side. The gold film is the thickest of these films and provides the electrical conduction to the p-side pad metal 21. The titanium film has excellent adhesion with the silver of the reflective metal 20. The platinum film prevents diffusion of the gold film.

The n-side pad metal 23 is provided on the n-side electrode 22. The n-side pad metal 23 also covers the end portion (the side surface) of the n-side electrode 22. The n-side pad metal 23 is thicker than the n-side electrode 22.

The semiconductor light emitting device 1 can be mounted to a mounting substrate using the p-side pad metal 21 and the n-side pad metal 23 as external terminals. For example, the semiconductor light emitting device 1 can be mounted to the mounting substrate in a state in which the first surface 15a faces upward from the mounting surface of the mounting substrate.

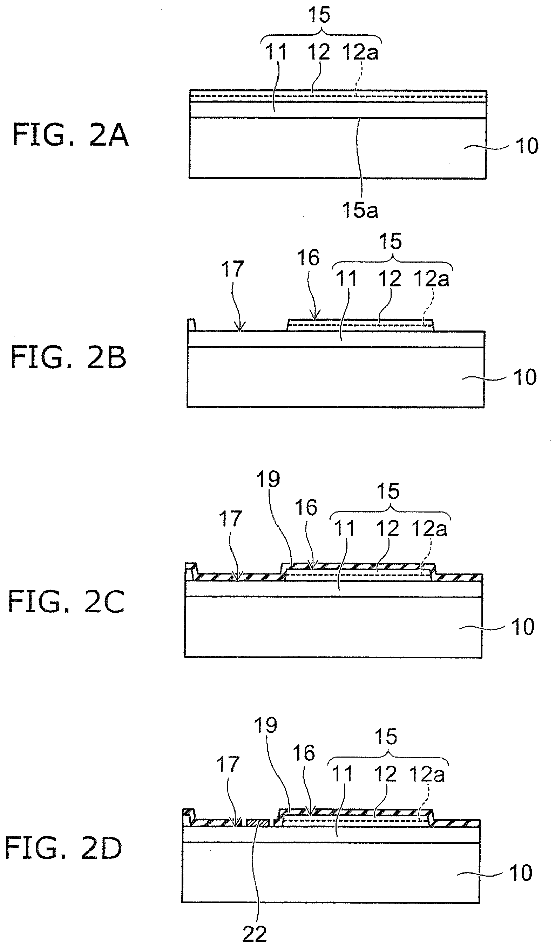

A method for manufacturing the semiconductor light emitting device 1 of the first embodiment will now be described with reference to FIG. 2A to FIG. 5E.

FIG. 2A to FIG. 4D are schematic cross-sectional views illustrating the method for manufacturing the semiconductor light emitting device 1.

FIGS. 5A to 5E are schematic plan views of the light emitting region 16 of the second surface of the semiconductor layer 15 where the p-side electrode 14 is formed.

FIG. 2A illustrates the cross section of a wafer in which a semiconductor layer 15 that includes the first semiconductor layer 11 and the second semiconductor layer 12 is formed on a major surface of a substrate 10. The first semiconductor layer 11 is formed on the major surface of the substrate 10; and the second semiconductor layer 12 is formed on the first semiconductor layer 11.

For example, the first semiconductor layer 11 and the second semiconductor layer 12 that are made of a gallium nitride material are epitaxially grown on a sapphire substrate by metal organic chemical vapor deposition (MOCVD).

After forming the semiconductor layer 15 on the substrate 10, a portion of the first semiconductor layer 11 is exposed by selectively removing the second semiconductor layer 12 including the light emitting layer 12a by, for example, Reactive Ion Etching (RIE) using a not-illustrated resist as illustrated in FIG. 2B. The upper surface of the second semiconductor layer 12 including the light emitting layer 12a becomes the light emitting region 16; and the region where the first semiconductor layer 11 is exposed becomes the non-light emitting region 17 which does not include the light emitting layer 12a.

After patterning the second surface of the semiconductor layer 15 as described above, the silicon oxide film 19 is formed on the entire surface of the second surface as illustrated in FIG. 2C. Subsequently, a portion of the silicon oxide film 19 that is on the non-light emitting region 17 is removed; and the n-side electrode 22 is formed at the portion from which the silicon oxide film 19 is removed as illustrated in FIG. 2D. The n-side electrode 22 has an ohmic contact with the second surface.

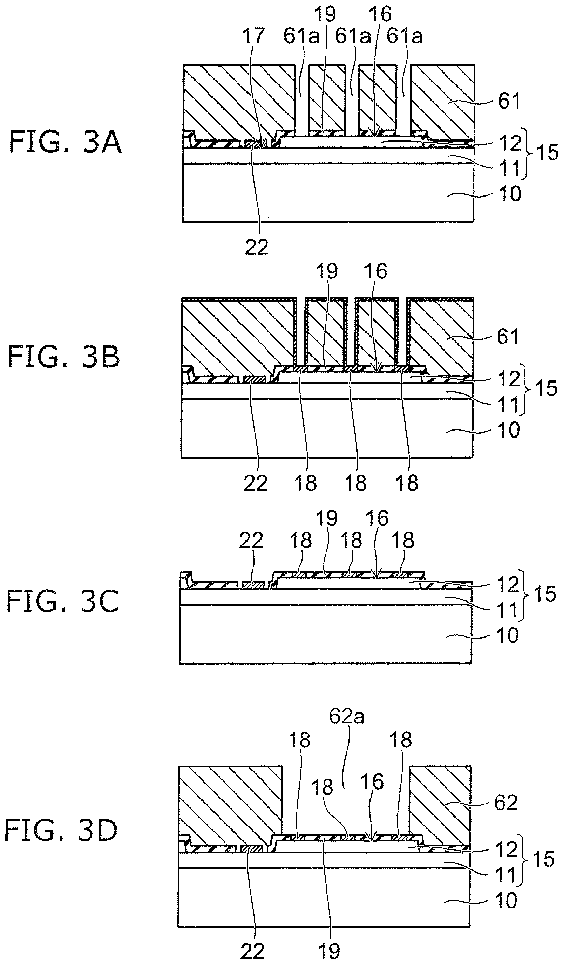

After forming the n-side electrode 22, the resist film 61 illustrated in FIG. 3A is formed on the entire surface of the wafer. Multiple holes 61a are made in the resist film 61 by performing photolithography and developing of the resist film 61. The silicon oxide film 19 that is on the light emitting region 16 is selectively etched using the resist film 61 as a mask. Accordingly, as illustrated in FIG. 5A, the second semiconductor layer 12 is exposed at the bottom portions of the holes 61a.

Subsequently, as illustrated in FIG. 3B, the contact metal 18 is formed as a film using the resist film 61 as a mask. The contact metal 18 is formed on the side walls of the holes 61a and the second semiconductor layer 12 exposed at the bottom portions of the holes 61a.

Then, as illustrated in FIG. 3C and FIG. 5B, the plurality of contact metal 18 selectively remains on the light emitting region 16 by removing the resist film 61. The plurality of contact metal 18 is filled into the openings selectively made in the silicon oxide film 19.

Subsequently, the resist film 62 illustrated in FIG. 3D is formed on the entire surface of the wafer. An opening 62a is made in the resist film 62 by performing photolithography and developing of the resist film 62. The region where the plurality of contact metal 18 is formed is exposed at the bottom portion of the opening 62a as illustrated in FIG. 5C.

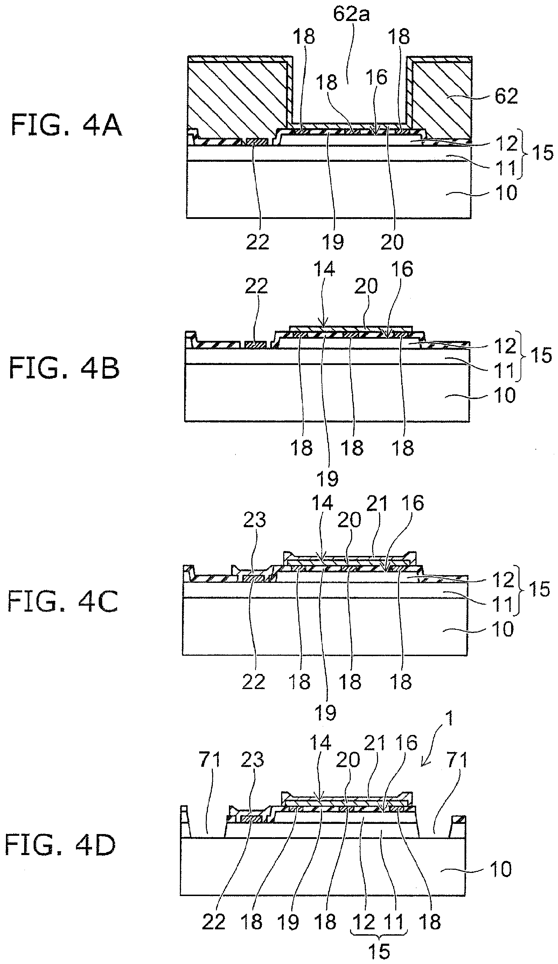

Then, as illustrated in FIG. 4A, the reflective metal 20 is formed as a film using the resist film 62 as a mask. The reflective metal 20 is formed on the silicon oxide film 19 and on the plurality of contact metal 18 exposed at the bottom portion of the opening 62a.

Subsequently, as illustrated in FIG. 4B, the reflective metal 20 remains on the silicon oxide film 19 and on the contact metal 18 in the light emitting region 16 by removing the resist film 62. As illustrated in FIG. 5D, the reflective metal 20 is formed to spread over substantially the entire surface of the light emitting region 16.

Then, as illustrated in FIG. 4C, the p-side pad metal 21 is formed on the reflective metal 20; and the n-side pad metal 23 is formed on the n-side electrode 22. As illustrated in FIG. 5E, the p-side pad metal 21 covers the entire surface of the reflective metal 20.

The reflective metal 20 may be formed also on the n-side electrode 22 when forming the reflective metal 20 on the light emitting region 16. In such a case, the formation of the n-side pad metal 23 of the process of FIG. 4C can be omitted because the reflective metal 20 formed on the n-side electrode 22 also can be used as the n-side pad metal.

Subsequently, as illustrated in FIG. 4D, the semiconductor layer 15 is separated into a plurality on the substrate 10 by making a trench 71 in the semiconductor layer 15 to reach the substrate 10. Then, singulation of the multiple semiconductor light emitting devices 1 is performed by peeling the substrate 10 from the semiconductor layer 15. Alternatively, the singulation of the multiple semiconductor light emitting devices 1 may be performed by cutting the substrate 10 at the position of the trench 71 in the state in which the substrate remains on the first surface 15a.

A fluorescer layer, a lens, and the like also may be formed on the first surface 15a.

### Second embodiment

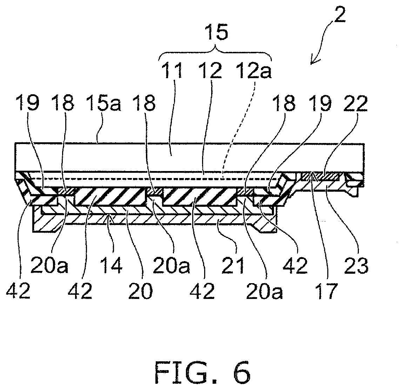

FIG. 6 is a schematic cross-sectional view of a semiconductor light emitting device 2 of a second embodiment.

In the semiconductor light emitting device 2 of the second embodiment as well, the p-side electrode 14 is provided in the light emitting region 16 of the second surface; and the n-side electrode 22 is provided in the non-light emitting region 17 of the second surface.

The p-side electrode 14 includes the plurality of contact metal 18, silicon oxide films 19 and 42 as transparent films that are transmissive with respect to the light emitted by the light emitting layer 12a, and the reflective metal 20.

The plurality of contact metal 18 is selectively provided on the second semiconductor layer 12 in contact with the second surface of the semiconductor layer 15. The silicon oxide films 19 and 42 which have transmittances with respect to the light emitted by the light emitting layer 12a that are higher than that of the contact metal 18 are provided between the plurality of contact metal 18. The silicon oxide films 19 and 42 are provided on the second semiconductor layer 12 in contact with the second surface to fill between the plurality of contact metal 18. The surface area of the silicon oxide films 19 and 42 on the light emitting region 16 on the semiconductor layer 15 side is greater than the sum total of the surface area of the plurality of contact metal 18 contacting the semiconductor layer 15.

The reflective metal 20 is provided on the plurality of contact metal 18 and the silicon oxide films 19 and 42. The reflective metal 20 spreads over substantially the entire light emitting region 16. The surface area of the surface of the reflective metal 20 on the semiconductor layer 15 side (the contact surface between the reflective metal 20 and the contact metal 18 and the contact surface between the reflective metal 20 and the silicon oxide film 42) is greater than the sum total of the surface area of the plurality of contact metal 18 contacting the semiconductor layer 15.

The reflective metal 20 contacts the contact metal 18 by a via 20a piercing the silicon oxide film 42 and is electrically connected to the contact metal 18.

The film thickness of the contact metal 18 between the reflective metal 20 and the semiconductor layer 15 is thinner than the film thickness of the silicon oxide film 42 between the reflective metal 20 and the semiconductor layer 15; and the via 20a which is a portion of the reflective metal 20 is provided on the contact metal 18 between the silicon oxide film 42.

In the second embodiment as well, the reflective metal 20 which includes silver functions as a reflective film such that the light travelling toward the side opposite to the first surface 15a which is the main extraction surface of the light to the outside is reflected by the reflective metal 20 toward the first surface 15a side. The contact metal 18 contacts the semiconductor layer 15 without the reflective metal 20 contacting the semiconductor layer 15. In other words, in the p-side electrode 14, the contact metal 18 provides the electrical conduction to the semiconductor layer 15.

Accordingly, in the second embodiment as well, both high light reflectivity and low contact resistance of the p-side electrode 14 of the semiconductor light emitting device 2 can be realized.

At the portion between the second surface of the semiconductor layer 15 and the reflective metal 20 where the contact metal 18 is not provided, the silicon oxide film 42 or a stacked film of the silicon oxide film 19 and the silicon oxide film 42 is provided as a transparent film having a higher transmittance than that of the contact metal 18 with respect to the light emitted by the light emitting layer 12a.

The surface area of the surface of the silicon oxide films 19 and 42 on the semiconductor layer 15 side is greater than the sum total of the surface area of the plurality of contact metal 18 contacting the semiconductor layer 15; and the surface area of the surface of the silicon oxide films 19 and 42 on the reflective metal 20 side is greater than the sum total of the surface area of the plurality of contact metal 18 contacting the reflective metal 20. Accordingly, a large reflective surface can be ensured for the surface of the reflective metal 20 on the semiconductor layer 15 side (the light emitting layer 12a side).

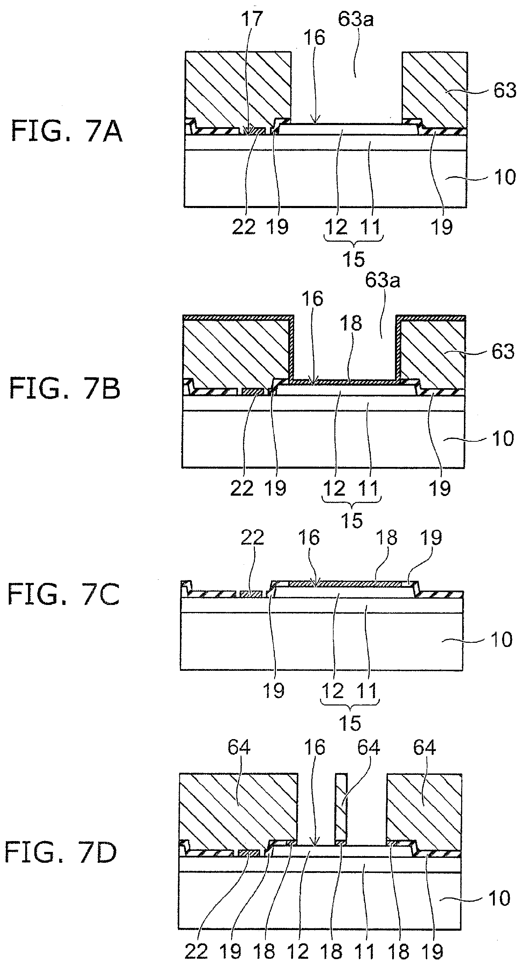

A method for manufacturing the semiconductor light emitting device 2 of the second embodiment will now be described with reference to FIG. 7A to FIG. 10F.

FIG. 7A to FIG. 9D are schematic cross-sectional views illustrating the method for manufacturing the semiconductor light emitting device 2.

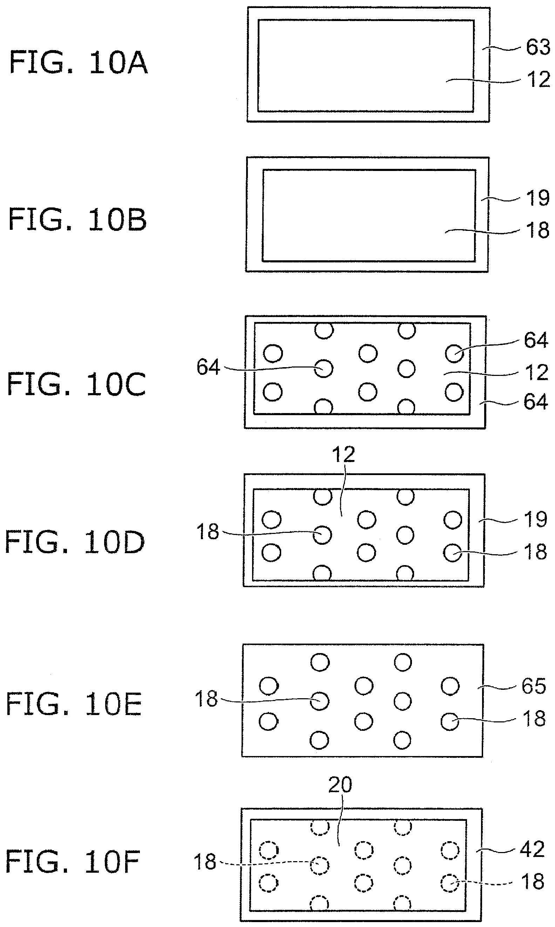

FIGS. 10A to 10F are schematic plan views of the light emitting region 16 of the second surface of the semiconductor layer 15 where the p-side electrode 14 is formed.

The processes up to the process illustrated in FIG. 2D proceed similarly to the first embodiment described above.

Subsequently, the resist film 61 illustrated in FIG. 3A is formed on the entire surface of the wafer. The multiple holes 61a are made in the resist film 61 by performing photolithography and developing of the resist film 61. The silicon oxide film 19 that is on the light emitting region 16 is selectively etched using the resist film 61 as a mask. Accordingly, as illustrated in FIG. 5A, the second semiconductor layer 12 is exposed at the bottom portions of the holes 61a.

Subsequently, as illustrated in FIG. 3B, the contact metal 18 is formed as a film using the resist film 61 as a mask. The contact metal 18 is formed on the side walls of the holes 61a and the second semiconductor layer 12 exposed at the bottom portions of the holes 61a.

Then, the plurality of contact metal 18 selectively remains on the light emitting region 16 as illustrated in FIG. 3C and FIG. 5B by removing the resist film 61. The plurality of contact metal 18 is filled into the openings selectively made in the silicon oxide film 19.

Subsequently, a resist film 63 illustrated in FIG. 7A is formed on the entire surface of the wafer. An opening 63a is made in the resist film 63 by performing photolithography and developing of the resist film 63. As illustrated in FIG. 10A, the second semiconductor layer 12 of the light emitting region 16 is exposed at the bottom portion of the opening 63a.

Then, as illustrated in FIG. 7B, the contact metal 18 is formed as a film using the resist film 63 as a mask. The contact metal 18 is formed on the second surface of the second semiconductor layer 12 exposed at the bottom portion of the opening 63a.

Subsequently, as illustrated in FIG. 7C and FIG. 10B, the contact metal 18 remains on the second surface of the second semiconductor layer 12 in the light emitting region 16 by removing the resist film 63.

After forming the contact metal 18, a resist film 64 illustrated in FIG. 7D is formed on the entire surface of the wafer. The resist film 64 selectively remains on the light emitting region 16 as illustrated in FIG. 10C by performing photolithography and developing of the resist film 64. The contact metal 18 is selectively removed by etching using the resist film 64 as a mask.

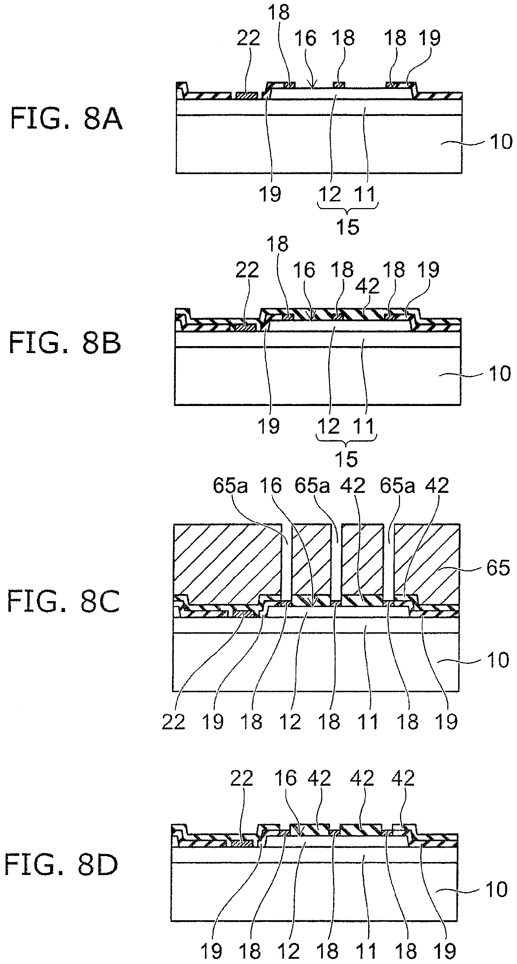

Subsequently, the plurality of contact metal 18 selectively remains on the light emitting region 16 as illustrated in FIG. 8A and FIG. 10D by removing the resist film 64.

Then, after forming the silicon oxide film 42 illustrated in FIG. 8B on the entire surface of the wafer, a resist film 65 illustrated in FIG. 8C is formed on the silicon oxide film 42. Holes 65a are made in the resist film 65 to reach the contact metal 18 by performing photolithography and developing of the resist film 65. Accordingly, as illustrated in FIG. 10E, the contact metal 18 is exposed at the bottom portions of the holes 65a.

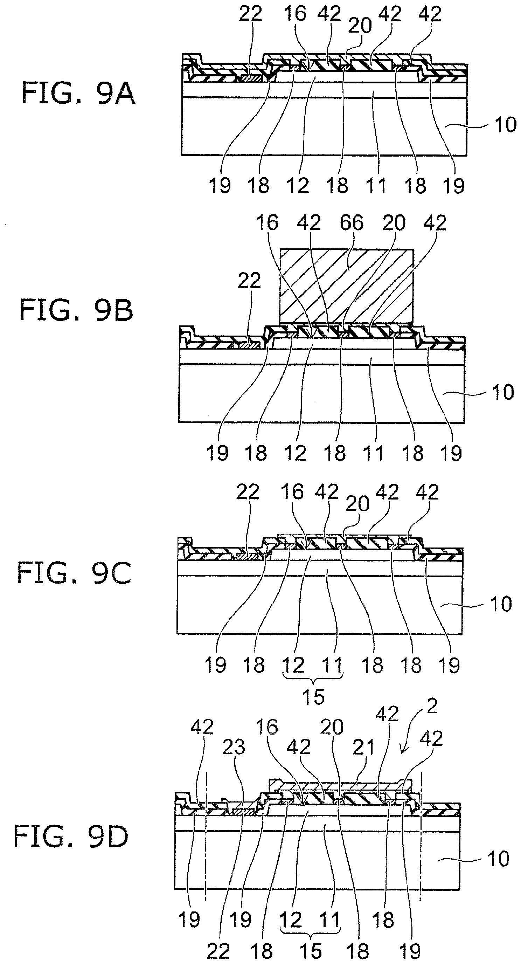

Subsequently, after removing the resist film 65 as illustrated in FIG. 8D, the reflective metal 20 is formed on the entire surface of the wafer as illustrated in FIG. 9A. The reflective metal 20 is connected to the contact metal 18 through the openings made in the silicon oxide film 42.

Then, as illustrated in FIG. 9B, the reflective metal 20 other than that of the light emitting region 16 is removed by etching using a resist film 66 that is selectively formed on the reflective metal 20 of the light emitting region 16 as a mask.

Thereby, as illustrated in FIG. 9C, the reflective metal 20 remains on the light emitting region 16. As illustrated in FIG. 10F, the reflective metal 20 is formed over substantially the entire surface of the light emitting region 16.

Subsequently, as illustrated in FIG. 9D, the p-side pad metal 21 is formed on the reflective metal 20; and the n-side pad metal 23 is formed on the n-side electrode 22.

In the second embodiment as well, the reflective metal 20 may be provided on the n-side electrode 22; and in such a case, the formation of the n-side pad metal 23 in the process of FIG. 9D can be omitted because the reflective metal 20 formed on the n-side electrode 22 also can be used as the n-side pad metal.

Subsequently, after removing the substrate 10 or with the substrate 10 remaining, singulation of the multiple semiconductor light emitting devices 2 is performed by dicing at the position illustrated by the single dot-dash line in FIG. 9D.

### Third embodiment

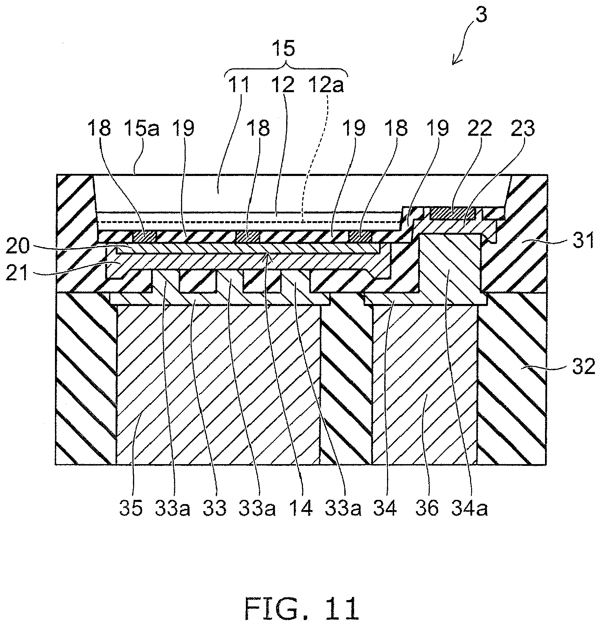

FIG. 11 is a schematic cross-sectional view of a semiconductor light emitting device 3 of a third embodiment.

In addition to the components of the semiconductor light emitting device 1 of the first embodiment described above and illustrated in FIG. 1, the semiconductor light emitting device 3 of the third embodiment further includes a first insulating layer (hereinbelow, also called simply the insulating layer) 31, a p-side interconnect layer 33, an n-side interconnect layer 34, a p-type metal pillar 35, an n-side metal pillar 36, and a resin layer 32 that is used as a second insulating layer.

The p-side electrode 14, the n-side electrode 22, the p-side pad metal 21, and the n-side pad metal 23 are covered with the insulating layer 31 in the semiconductor light emitting device 3. The first surface 15a of the semiconductor layer 15 is not covered with the insulating layer 31. The side surface of the semiconductor layer 15 continuing from the first surface 15a is covered with the insulating layer 31. The insulating layer 31 and the resin layer 32 that is stacked on the insulating layer 31 together form the side surface of the semiconductor light emitting device 3.

The insulating layer 31 may include, for example, a resin such as polyimide, etc., having excellent patternability of fine openings. Alternatively, an inorganic substance such as silicon oxide, silicon nitride, etc., may be used as the insulating layer 31.

The p-side interconnect layer 33 and the n-side interconnect layer 34 are provided apart from each other on the insulating layer 31. The p-side interconnect layer 33 is electrically connected to the p-side pad metal 21 and the p-side electrode 14 by multiple first vias 33a piercing the insulating layer 31. The n-side interconnect layer 34 is electrically connected to the n-side pad metal 23 and the n-side electrode 22 by a second via 34a piercing the insulating layer 31.

The p-type metal pillar 35 which is thicker than the p-side interconnect layer 33 is provided on the p-side interconnect layer 33. The p-side interconnect unit includes the p-side interconnect layer 33 and the p-type metal pillar 35.

The n-side metal pillar 36 which is thicker than the n-side interconnect layer 34 is provided on the n-side interconnect layer 34. The n-side interconnect unit includes the n-side interconnect layer 34 and the n-side metal pillar 36.

The resin layer 32 is provided on the insulating layer 31. The resin layer 32 covers the periphery of the p-side interconnect unit and the periphery of the n-side interconnect unit. The resin layer 32 is provided between the p-type metal pillar 35 and the n-side metal pillar 36 to cover the side surface of the p-type metal pillar 35 and the side surface of the n-side metal pillar 36.

The surface of the p-type metal pillar 35 on the side opposite to the p-side interconnect layer 33 is exposed without being covered with the resin layer 32 and functions as a p-side external terminal bonded to the mounting substrate. The surface of the n-side metal pillar 36 on the side opposite to the n-side interconnect layer 34 is exposed without being covered with the resin layer 32 and functions as an n-side external terminal bonded to the mounting substrate.

The thicknesses of the p-side interconnect unit, the n-side interconnect unit, and the resin layer 32 are thicker than the thickness of the semiconductor layer 15. The p-type metal pillar 35, the n-side metal pillar 36, and the resin layer 32 that reinforces the p-type metal pillar 35 and the n-side metal pillar 36 function as a support body of the semiconductor layer 15. Accordingly, by the support body including the p-type metal pillar 35, the n-side metal pillar 36, and the resin layer 32, the semiconductor layer 15 can be stably supported and the mechanical strength of the semiconductor light emitting device 3 can be increased even in the case where the substrate 10 used to form the semiconductor layer 15 is removed.

The stress applied to the semiconductor layer 15 in the state in which the semiconductor light emitting device 3 is mounted to the mounting substrate can be relieved by being absorbed by the p-type metal pillar 35 and the n-side metal pillar 36.

Copper, gold, nickel, silver, and the like may be used as the materials of the p-side interconnect layer 33, the n-side interconnect layer 34, the p-type metal pillar 35, and the n-side metal pillar 36. Of these, good thermal conductivity, high migration resistance, and excellent adhesion with insulating materials are obtained when copper is used.

It is desirable for the resin layer 32 to have a coefficient of thermal expansion near to or the same as that of the mounting substrate. Examples of such a resin layer include an epoxy resin, a silicone resin, a fluorocarbon resin, etc.

The surface area of the n-side interconnect layer 34 spreading over the insulating layer 31 is greater than the surface area of the n-side electrode 22. The connection surface area between the n-side interconnect layer 34 and the n-side metal pillar 36 is greater than the surface area where the n-side interconnect layer 34 is connected to the n-side electrode 22 by the via 34a.

A high light output can be obtained by the light emitting layer 12a spreading over a region that is larger than the n-side electrode 22. Also, in this structure, the n-side electrode 22 provided in the non-light emitting region 17 which is narrower than the light emitting region 16 is re-disposed as the n-side interconnect layer 34 on the mounting surface side to have a surface area greater than that of the n-side electrode 22.

The surface area where the p-side interconnect layer 33 is connected to the p-side pad metal 21 by the multiple vias 33a is greater than the surface area where the n-side interconnect layer 34 is connected to the n-side electrode 22 by a via 34b. Therefore, the current distribution to the light emitting layer 12a can be improved; and the heat dissipation of the heat generated at the light emitting layer 12a can be increased.

### Fourth embodiment

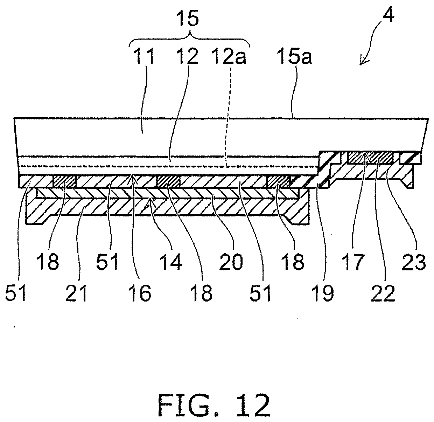

FIG. 12 is a schematic cross-sectional view of a semiconductor light emitting device 4 of a fourth embodiment.

The semiconductor light emitting device 4 of the fourth embodiment includes a conductive Indium Tin Oxide (ITO) film 51 as the transparent film provided between the second surface of the light emitting region 16 and the reflective metal 20.

In other words, the ITO film 51 having a transmittance with respect to the light emitted by the light emitting layer 12a that is higher than that of the contact metal 18 is provided between the plurality of contact metal 18. The ITO film 51 is provided on the second semiconductor layer 12 in contact with the second surface to fill between the plurality of contact metal 18. The surface area of the ITO film 51 on the light emitting region 16 is greater than the surface area of the plurality of contact metal 18. In other words, the surface area of the ITO film 51 contacting the second semiconductor layer 12 is greater than the sum total of the surface area of the plurality of contact metal 18 contacting the second semiconductor layer 12; and the surface area of the ITO film 51 contacting the reflective metal 20 is greater than the sum total of the surface area of the plurality of contact metal 18 contacting the reflective metal 20.

At the stepped portion between the light emitting region 16 and the non-light emitting region 17, the ITO film 51 is not provided; and, for example, the silicon oxide film 19 is provided as the insulating film. The silicon oxide film 19 of this stepped portion insulates the p-side electrode 14 from the n-side electrode 22 and insulates the p-side pad metal 21 from the n-side pad metal 23.

The reflective metal 20 is provided on the plurality of contact metal 18 and the ITO film 51. The reflective metal 20 is provided to spread over the plurality of contact metal 18 and the ITO film 51 with a surface area that is greater than the surface area of the plurality of contact metal 18. In other words, the surface area of the surface of the reflective metal 20 on the semiconductor layer 15 side is greater than the sum total of the surface area of the plurality of contact metal 18 contacting the semiconductor layer 15.

The reflective metal 20 contacts the plurality of contact metal 18 and the ITO film 51 and is electrically connected to the contact metal 18 and the ITO film 51.

In the semiconductor light emitting device 4 of the fourth embodiment as well, the reflective metal 20 which includes silver functions as a reflective film such that the light travelling toward the side opposite to the first surface 15a which is the main extraction surface of the light to the outside is reflected by the reflective metal 20 toward the first surface 15a side.

The contact metal 18 contacts the semiconductor layer 15 without the reflective metal 20 contacting the semiconductor layer 15. In other words, in the p-side electrode 14, the contact metal 18 provides the electrical conduction to the semiconductor layer 15. Further, in the fourth embodiment, the ITO film 51 also provides an electrical connection between the semiconductor layer 15 and the reflective metal 20 because the conductive ITO film 51 is used as the transparent film provided between the semiconductor layer 15 and the reflective metal 20. Accordingly, in the fourth embodiment, it is easy to supply the current uniformly over the entire light emitting layer 12a in the surface direction.

In the fourth embodiment as well, both high light reflectivity and low contact resistance of the p-side electrode 14 of the semiconductor light emitting device 4 can be realized.

At the portion between the second surface of the semiconductor layer 15 and the reflective metal 20 where the contact metal 18 is not provided, the ITO film 51 is provided as the transparent film having a higher transmittance than that of the contact metal 18 with respect to the light emitted by the light emitting layer 12a. The surface area of the surface of the ITO film 51 on the semiconductor layer 15 side is greater than the sum total of the surface area of the plurality of contact metal 18 contacting the semiconductor layer 15; and the surface area of the surface of the ITO film 51 on the reflective metal 20 side is greater than the sum total of the surface area of the plurality of contact metal 18 contacting the reflective metal 20. Accordingly, a large reflective surface can be ensured for the surface of the reflective metal 20 on the semiconductor layer 15 side (the light emitting layer 12a side).

In the embodiments described above, the p-side electrode 14 and the n-side electrode 22 are provided on the second surface on the side opposite to the first surface 15a which is the main extraction surface of the light. Accordingly, both high light reflectivity and low contact resistance of the n-side electrode 22 can be realized by the n-side electrode 22 also having a structure similar to that of the p-side electrode 14 in which the n-side electrode 22 includes a reflective metal including silver, a contact metal, and a transparent film.

### Fifth embodiment

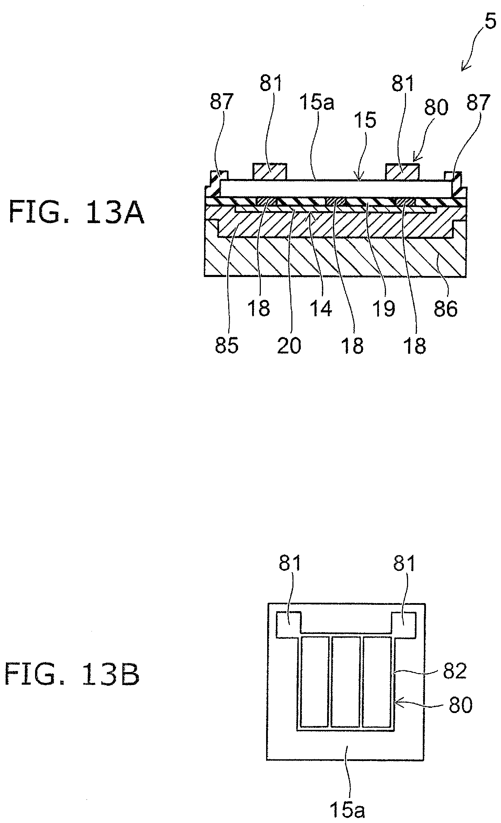

FIG. 13A is a schematic cross-sectional view of a semiconductor light emitting device 5 of a fifth embodiment.

FIG. 13B is a schematic plan view illustrating an example of the planar pattern of an n-side electrode 80 of the semiconductor light emitting device 5.

In the semiconductor light emitting device 5 of the fifth embodiment as well, the light is extracted to the outside mainly from the first surface 15a of the semiconductor layer 15. The p-side electrode 14 is provided on the second surface of the semiconductor layer 15 on the side opposite to the first surface 15a.

Similarly to the first embodiment, the p-side electrode 14 includes the plurality of contact metal 18, the silicon oxide film 19 as a transparent film that is transmissive with respect to the light emitted by the light emitting layer, and the reflective metal 20 that is reflective with respect to the light emitted by the light emitting layer.

The plurality of contact metal 18 is selectively provided on the semiconductor layer 15 in contact with the second surface of the semiconductor layer 15. The silicon oxide film 19 having a transmittance with respect to the light emitted by the light emitting layer that is higher than that of the contact metal 18 is provided between the plurality of contact metal 18. The silicon oxide film 19 is provided on the semiconductor layer 15 in contact with the second surface to fill between the plurality of contact metal 18.

The reflective metal 20 is provided on the silicon oxide film 19 and the plurality of contact metal 18. The reflective metal 20 is provided to spread over the plurality of contact metal 18 and the silicon oxide film 19 with a surface area that is greater than the surface area of the plurality of contact metal 18.

The reflective metal 20 spreads over substantially the entire light emitting region of the second surface. The reflective metal 20 contacts the plurality of contact metal 18 and is electrically connected to the plurality of contact metal 18.

In the fifth embodiment as well, the contact metal 18 contacts the semiconductor layer 15 without the reflective metal 20 contacting the semiconductor layer 15. In other words, in the p-side electrode 14, the contact metal 18 provides the electrical conduction to the semiconductor layer 15.

The reflective metal 20 is provided to spread over substantially the entire light emitting region of the second surface; and the sum total of the surface area of the plurality of contact metal 18 that has a reflectance lower than that of the reflective metal 20 and contacts the semiconductor layer 15 is less than the surface area of the surface of the reflective metal 20 on the semiconductor layer 15 side.

Accordingly, in the fifth embodiment as well, both high light reflectivity and low contact resistance of the p-side electrode 14 of the semiconductor light emitting device 5 can be realized.

At the portion between the second surface of the semiconductor layer 15 and the reflective metal 20 where the contact metal 18 is not provided, the silicon oxide film 19 is provided as a transparent film having a higher transmittance than that of the contact metal 18 with respect to the light emitted by the light emitting layer. The surface area of the surface of the silicon oxide film 19 on the semiconductor layer 15 side is greater than the sum total of the surface area of the plurality of contact metal 18 contacting the semiconductor layer 15; and the surface area of the surface of the silicon oxide film 19 on the reflective metal 20 side is greater than the sum total of the surface area of the plurality of contact metal 18 contacting the reflective metal 20. Accordingly, a large reflective surface can be ensured for the surface of the reflective metal 20 on the semiconductor layer 15 side (the light emitting layer 12a side).

The reflective metal 20 is covered with the p-side pad metal 85. The p-side pad metal 85 is covered with a metal layer 86. The metal layer 86 functions as a support body of the semiconductor layer 15 and as an external terminal on the p side.

In the semiconductor light emitting device 5 of the fifth embodiment, the n-side electrode 80 is provided on the first surface 15a. As illustrated in FIG. 13B, the n-side electrode 80 includes a pad portion 81 and a fine electrode portion 82. The pad portion 81 functions as the external terminal on the n side. The fine electrode portion 82 performs the role of diffusing the current in the surface direction of the semiconductor layer 15.

The side surface of the semiconductor layer 15 continuing from the first surface 15a is covered with an insulating film 87. The insulating film 87 may include a silicon oxide film, a silicon nitride film, a resin film, and the like.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.
Further disclosure is provided in the following paragraphs:
1. A semiconductor light emitting device, comprising:
   a semiconductor layer (15) including a light emitting layer (12a), a first surface (15a), and a second surface on a side opposite to the first surface (15a);
   a p-side electrode (14) provided on the second surface; and
   an n-side electrode (22, 80) provided on the semiconductor layer (15) to be separated from the p-side electrode (14),
   the p-side electrode (14) including:
      a plurality of contact metal (18) selectively provided on the semiconductor layer (15) in contact with the second surface;
      a transparent film (19, 42, 51) provided on the semiconductor layer (15) in contact with the second surface between the plurality of contact metal (18), a transmittance of the transparent film (19, 42, 51) with respect to light emitted by the light emitting layer (12a) being higher than a transmittance of the contact metal (18) with respect to the light emitted by the light emitting layer (12a); and
      a reflective metal (20) provided on the contact metal (18) and on the transparent film (19, 42, 51) in contact with the contact metal (18), the reflective metal (20) including silver,
   a surface area of a surface of the reflective metal (20) on the light emitting layer (12a) side being greater than the sum total of a surface area of the plurality of contact metal (18) contacting the semiconductor layer (15).
2. The device according to para. 1, wherein a surface area of a surface of the transparent film (19, 42, 51) on the semiconductor layer (15) side is greater than the sum total of the surface area of the plurality of contact metal (18) contacting the semiconductor layer (15), and a surface area of a surface of the transparent film (19, 42, 51) on the reflective metal (20) side is greater than the sum total of a surface area of the plurality of contact metal (18) contacting the reflective metal (20).
3. The device according to para. 1 or 2, wherein the contact metal (18) includes at least one selected from nickel, gold, and rhodium.
4. The device according to any of paras. 1-3, wherein the transparent film (19, 42) is a silicon oxide film.
5. The device according to any of paras. 1-3, wherein the transparent film (51) is an Indium Tin Oxide (ITO) film.
6. The device according to any of paras. 1-5, wherein a Schottky barrier height between the contact metal (18) and a semiconductor of a portion of the semiconductor layer (15) contacting the contact metal (18) is less than a Schottky barrier height between the semiconductor and the reflective metal (20).
7. The device according to any of paras. 1-6, wherein a reflectance of the contact metal (18) with respect to the light emitted by the light emitting layer (12a) is lower than a reflectance of the reflective metal (20) with respect to the light emitted by the light emitting layer (12a).
8. The device according to any of paras. 1-7, wherein a film thickness of the contact metal (18) between the reflective metal (20) and the semiconductor layer (15) is substantially the same as a film thickness of the transparent film (19, 51) between the reflective metal (20) and the semiconductor layer (15).
9. The device according to any of paras. 1-7, wherein:
   a film thickness of the contact metal (18) between the reflective metal (20) and the semiconductor layer (15) is thinner than a film thickness of the transparent film (42) between the reflective metal (20) and the semiconductor layer (15); and
   the reflective metal (20a) is provided on the contact metal (18) between the transparent film (42).
10. The device according to any of paras. 1-9, wherein:
   the second surface has a light emitting region (16) opposing the light emitting layer (12a) and a non-light emitting region (17) not opposing the light emitting layer (12a); and
   the p-side electrode (14) is provided in the light emitting region (16) of the second surface, and the n-side electrode (22) is provided in the non-light emitting region (17) of the second surface.
11. The device according to para. 10, wherein the sum total of the surface area of the plurality of contact metal (18) contacting the semiconductor layer (15) is less than a surface area of the light emitting region (16) of the second surface.
12. The device according to para. 10 or 11, further comprising:
   a first insulating layer (31) provided on the second surface side;
   a p-side interconnect unit provided on the first insulating layer (31) to be connected to the p-side electrode (14) by a first via (33a) piercing the first insulating layer (31); and
   an n-side interconnect unit provided on the first insulating layer (31) to be connected to the n-side electrode (22) by a second via (34a) piercing the first insulating layer (31).
13. The device according to para. 12, wherein:
   the p-side interconnect unit includes
      a p-side interconnect layer (33) provided on the first insulating layer (31), and
      a p-type metal pillar (35) provided on the p-side interconnect layer (33), the p-type metal pillar (35) being thicker than the p-side interconnect layer (33); and
   the n-side interconnect unit includes
      an n-side interconnect layer (34) provided on the first insulating layer (31), and
      an n-side metal pillar (36) provided on the n-side interconnect layer (34), the n-side metal pillar (36) being thicker than the n-side interconnect layer (34).
14. The device according to para. 12 or 13, further comprising a second insulating layer (32) provided between the p-side interconnect unit and the n-side interconnect unit.
15. The device according to any of paras. 12-14, wherein the first insulating layer (31) covers a side surface of the semiconductor layer (15) continuing from the first surface (15a).
16. The device according to any of paras. 13-15, wherein a connection surface area between the n-side interconnect layer (34) and the n-side metal pillar (36) is greater than a connection surface area between the n-side interconnect layer (34) and the n-side electrode (22).

## Claims

1. A semiconductor light emitting device, comprising:
a semiconductor layer (15) including a light emitting layer (12a), a first surface (15a), a second surface on a side opposite to the first surface (15a);
a p-side electrode (14) provided on the second surface; and
an n-side electrode (22, 80) provided on the semiconductor layer (15) to be separated from the p-side electrode (14),
the p-side electrode (14) including:
a plurality of contact metal (18) selectively provided on the semiconductor layer (15) in contact with the second surface;
a transparent film (42) provided on the semiconductor layer (15) in contact with the second surface between the plurality of contact metal (18), a transmittance of the transparent film (42) with respect to light emitted by the light emitting layer (12a) being higher than a transmittance of the contact metal (18) with respect to the light emitted by the light emitting layer (12a); and
a reflective metal (20) provided on the contact metal (18) and on the transparent film (42) in contact with the contact metal (18),
a film thickness of the contact metal (18) between the reflective metal (20) and the semiconductor layer (15) is thinner than a film thickness of the transparent film (42) between the reflective metal (20) and the semiconductor layer (15), and
the reflective metal (20) is provided on the contact metal (18) and on the transparent film (42) in contact with the contact metal (18).

2. The device according to claim 1, wherein the reflective metal (20) includes silver as a main component.

3. The device according to claim 1 or 2, wherein the contact metal (18) includes at least one selected from nickel, gold, and rhodium.

4. The device according to any of claims 1-3, wherein a Schottky barrier height between the contact metal (18) and a semiconductor of a portion of the semiconductor layer (15) contacting the contact metal (18) is less than a Schottky barrier height between the semiconductor and the reflective metal (20).

5. The device according to any of claims 1-3, wherein a reflectance of the contact metal (18) with respect to the light emitted by the light emitting layer (12a) is lower than a reflectance of the reflective metal (20) with respect to the light emitted by the light emitting layer (12a).

6. The device according to any of claims 1-5, wherein the reflective metal (20) is in contact with the plurality of contact metal (18).

7. The device according to any of claims 1-5, wherein the reflective metal (20) is in contact with the plurality of contact metal (18) and the transparent film (42).

8. The device according to any of claims 1-7, wherein:
the second surface has a light emitting region (16) opposing the light emitting layer (12a) and a non-light emitting region (17) not opposing the light emitting layer (12a); and
the p-side electrode (14) is provided in the light emitting region (16) of the second surface, and the n-side electrode (22) is provided in the non-light emitting region (17) of the second surface.

9. The device according to claim 8, wherein a sum total of the surface area of the plurality of contact metal (18) contacting the semiconductor layer (15) is less than a surface area of the light emitting region (16) of the second surface.

10. The device according to claim 8 or 9, further comprising:
a first insulating layer (31) provided on the second surface side;
a p-side interconnect unit (33, 35) provided on the first insulating layer (31), to be connected to the p-side electrode (14) by a first via (33a) piercing the first insulating layer (31); and
an n-side interconnect unit (34, 36) provided on the first insulating layer (31) to be connected to the n-side electrode (22) by a second via (34a) piercing the first insulating layer (31).

11. The device according to claim 10, wherein
the p-side interconnect unit (33, 35) includes
a p-side interconnect layer (33) provided on the first insulating layer (31), and
a p-type metal pillar (35) provided on the p-side interconnect layer (33), the p-type metal pillar (35) being thicker than the p-side interconnect layer (33); and
the n-side interconnect unit (34, 36) includes
an n-side interconnect layer (34) provided on the first insulating layer (31), and
an n-side metal pillar (36) provided on the n-side interconnect layer (34), the n-side metal pillar (36) being thicker than the n-side interconnect layer (34).

12. The device according to claim 10 or 11, further comprising a second insulating layer (32) provided between the p-side interconnect unit (33, 35) and the n-side interconnect unit(34, 36).

13. The device according to any of claims 10-12, wherein the first insulating layer (31) covers a side surface of the semiconductor layer (15) continuing from the first surface (15a).

14. The device according to any of claims 11-13, wherein a connection surface area between the n-side interconnect layer (34) and the n-side metal pillar (36) is greater than a connection surface area between the n-side interconnect layer (34) and the n-side electrode (22).

15. The device according to any of claims 1-14, wherein the device is mountable on a mounting substrate with the first surface (15a) facing upward from a mounting surface of the mounting substrate.
